# EUROPEAN PATENT APPLICATION

(11) **EP 4 847 659 A1**
(43) Date of publication of application: **02.12.2026**
(21) Application number: 25179239.6
(22) Date of filing: 27.05.2025
(51) Int. Cl.: C23C 14/00, C23C 14/06, C23C 14/18, C23C 28/00

(54) **METHOD AND DEVICE FOR DEPOSITING A CHEMICALLY MODIFIED METAL FILM**

(71) Applicant: Evatec AG, 9477 Trübbach (CH)
(72) Inventor: Tschirky, Thomas, 8887 Mels (CH); Crameri, Nino, 9436 Balgach (CH)
(74) Representative: Mantel, Berthold Friedrich

(57) **Abstract**

The present invention pertains to a method comprising the steps of depositing a metal film on a surface of a substrate by sputtering from a metal composition target under a first atmosphere and at least partially chemically modifying the deposited metal film and a surface of the metal composition target under a second atmosphere.

## Description

### TECHNICAL FIELD OF THE INVENTION

The present invention relates to the technical field of thin film deposition. In particular, the present invention pertains to substrates having a surface coated with a film and a device for depositing a film on a substrate.

### DESCRIPTION OF THE RELATED ART

Known methods and devices for depositing chemically modified metal films typically involve metal-organic chemical vapour deposition (MOCVD) or molecular beam epitaxy (MBE) which are expensive and/or require high growth temperatures, which in turn can damage substrates or previously deposited layers. Also, high doping levels are generally difficult to achieve with these established processes. Alternative known methods include reactive sputtering which, however, has previously been found to deliver an inferior layer quality compared to MOCVD and MBE.

### SUMMARY OF THE INVENTION

It is the objective of the present invention to provide an improved method and device for the deposition of a chemically modified metal film on a substrate, in particular a semiconductor film. A further objective is the provision of an improved substrate with a coated surface.

In a first aspect, the present invention is directed to a method for depositing a chemically modified metal film on a substrate, wherein the method comprises the steps:
(a) providing a substrate and a metal composition target in a vacuum chamber,
(b) depositing a metal film on a surface of the substrate by sputtering the metal from the metal composition target under a first atmosphere, and
(c) at least partially chemically modifying the deposited metal film and a surface of the metal composition target with a reactive gas under a second atmosphere,

wherein the first atmosphere optionally is an atmosphere comprising at least 40 vol% of a noble gas, and
wherein the second atmosphere is an atmosphere comprising the reactive gas.

The method may, e.g., yield a higher layer quality (e.g. epitaxial layers), allow for lower processing temperatures, yield high conductivities for doped metal films, as well as improve crystallinity and surface roughness of the sputtered metal film.

The substrate to be coated may be any substrate that is suitable for being coated by sputtering, e.g. sapphire or a Si-based substrate.

Step (b) may be carried out with means and parameters known to the skilled person in the art of sputtering and thin film deposition. The ions that cause sputtering may originate from known ion sources including plasma and particle accelerators (e.g. ion beam sputtering). Ionization in the plasma may be, e.g., further increased by the use of cold or hot cathodes, e.g. hot filament cathodes. The ions may be generated in the vacuum chamber in which the target and substrate are placed, or they may be generated in a separate chamber functionally connected to the vacuum chamber in which the metal composition target and substrate are placed. The ions for sputtering are ions of the gas component(s) of the first atmosphere.

The metal composition target may be suitable for sputtering and may be solid below 150°C, i.e. its melting temperature is above 150°C. One or multiple metal composition targets may be used in the present method, e.g. for co-sputtering.

During step (b), a metal film is deposited on the surface of the substrate by sputtering the metal (which forms the metal film on the surface of the substrate) from the metal composition target under a first atmosphere. The first atmosphere allows for sputtering but, together with other process parameters such as sputtering power, sputtering duration and/or temperature, does not or at least essentially does not cause a chemical modification of the metal composition target, the metal that is sputtered from the metal composition target and the metal that is deposited as a metal film on the substrate. In other words, metal accumulates on the substrate at a higher rate than a chemical modification of said metal can or could take place. The term "at least essentially does not cause a chemical modification" means that at most trace amounts of a metal are chemically reacted with a gas component of the first atmosphere during step (b), for example at most 1 mol% to 40 mol% or at most 10 mol%, 20 mol% or 40 mol% of the atoms of the metal which are deposited during step (b). In an embodiment, these values only refer to the atoms being deposited during step (b) and not to any atoms that are deposited in a previously conducted step (b) or that are provided on the substrate before step (b) by any other means. Optionally the term "at least essentially does not cause a chemical modification " means that at most 1 mol% to 40 mol% or at most 10 mol%, 20 mol% or 40 mol% of the surface atoms of the target of a metal are chemically reacted with a gas component of the first atmosphere during step (b). Typically, this first atmosphere comprises a noble gas, and further (gas) components may optionally be comprised to the extent that essentially no chemical modification as detailed above occurs during method step (b) under the chosen process parameters (e.g. as detailed above and below). For example, the first atmosphere may comprise or consist of a noble gas (e.g. Ar, Ne, Kr and/or Xe). In an alternative example, the first atmosphere may comprise, in addition to a noble gas, one or more (potentially) reactive gas components (such as, e.g., N₂, NH₃, N₂O, N₂H₄, methane, acetylene, propane, CO₂ and/or H₂S). It is within the purview of the skilled person to adjust the method parameters during step (b) so that the optional and potentially reactive gas components of the first atmosphere essentially do not react with the metal composition target, the metal that is sputtered from the metal composition target and the metal that is deposited as a metal film on the substrate during step (b) (the term "essentially do not react" can include some degree of modification as noted above in the context of the chemical modification). Also, for example, the reactive gas parts may be used to reduce the amount of metal overabundance which may exceed optimal conditions. For example, such process parameters include the volume ratio of the potentially reactive gas component relative to the noble gas in the first or second atmosphere, the sputter power, the sputtering power type (e.g. DC-sputtering including DC magnetron-sputtering, pulsed DC-sputtering, pulsed DC magnetron-sputtering, RF-sputtering or a combination of DC- and RF-sputtering), the sputtering temperature and/or the duration of step (b).

During step (b), a metal film of one or several atomic monolayers may be generated, depending on the duration and process conditions which can be routinely controlled by the skilled person. Step (b) may, e.g., be carried out up to and including metal droplet formation on the substrate.

After the metal film is deposited during step (b), this metal film and a surface of the metal composition target is at least partially chemically modified during step (c) of the present method. As used herein, the term "chemically modifying" refers to a chemical reaction of at least part of the deposited metal film (referring to those metal atoms that are deposited during the previous step (b), optionally more than one or all monolayers if more than one monolayer are deposited in the previous step (b), optionally at least the surface of the metal film) and the surface of the metal composition target with a further reactive gas comprised in the second atmosphere. The reaction of the deposited metal film and the surface of the metal composition target with a reactive gas comprised in the second atmosphere may be effected e.g. by ionizing the reactive gas, e.g. with a plasma. Exemplary chemical reactions include nitridation, oxidation, carbidation and sulfidation. These chemical modifications are usually achieved in the art by reactive sputtering, i.e. a process, wherein the sputtered metal reacts with a reactive gas during the sputter/deposition process. In the present method, however, the process of sputtering/deposition is separated from the process of chemical modification. In other words, the current method comprises a two-step procedure, wherein the metal is sputtered and deposited in a first step (step (b)) and subsequently chemically modified in a subsequent step (step (c)). Furthermore, in step (c) of the present method, at least part of the surface of the metal composition target may be chemically modified, essentially in analogy to the deposited metal film. The at least partial chemical modification of the surface of the metal composition target results in a reduction or even prevention of sputtering from the metal composition target during step (c), further aiding in the separation of the sputter/deposition process from the chemical modification process.

It is noted that, for all aspects and embodiments disclosed herein, the chemically modified metal film (e.g. a composition, such as a semiconductor, e.g. GaN) may have non-metallic properties.

The term "at least partially chemically modifying" in the context of the present method means that the deposited metal film of step (b) is chemically modified to a desired degree which may be chosen by the skilled person, e.g. depending on the material properties that should be obtained. The skilled person is aware that also those atoms of the metal film deposited during previous step (b) that are not exposed to the reactive gas (i.e. the metal atoms inside the layers or inside droplets of the film) may be chemically modified if the metal film includes more than one atomic monolayer. Exemplary degrees of chemical modification include complete chemical modification of all metal atoms of the metal film deposited during the previous step (b) to achieve a desired stoichiometry, optionally at least 60 mol% thereof.

The term "at least partially chemically modifying a surface of the metal composition target" in the context of the present method means that a surface of the metal composition target is chemically modified with a reactive gas to the extent that sputtering from the target is significantly reduced by the chemically modified surface, e.g. in that at least the surface area of the metal composition target that would be sputter-active (or is sputter-active in step (b)) is chemically modified. This modification may be considered a "poisoning" of the target. For example, "at least partially chemically modifying a surface of the metal composition target" and "significantly reducing sputtering from the target" means that at least the entire sputter-active surface of the target is chemically modified and/or that sputtering from the target is reduced by at least 50%, optionally at least 75% or 95% in step (c) compared to step (b).

The ions that cause the at least partial chemical modification of the deposited metal film and surface of the metal composition target in step (c) may originate from ion sources including plasma and particle accelerators (e.g. an ion beam). Ionization in the plasma may be, e.g., further increased by the use of cold or hot cathodes, e.g. hot filament cathodes. The ions may be generated in the vacuum chamber in which the target and substrate are placed, or they may be generated in a separate chamber functionally connected to the vacuum chamber in which the target and substrate are placed. The ion source may ionize gas component(s) of the second atmosphere and optionally has no separate gas source. In an example, step (c) involves the generation of a plasma of the second atmosphere including the reactive gas in effective proximity to the metal film and the metal composition target surface to achieve the chemical modification. For example, the power and means for sputtering used in step (b) can be used for plasma generation in step (c), although the amounts and type of power (i.e. these process parameters) may vary between steps (b) and (c).

The second atmosphere for use in the present invention comprises a reactive gas (such as, e.g., N₂, NH₃, N₂O, N₂H₄, methane, acetylene, propane, CO₂ and/or H₂S) which allows for the at least partial chemical modification of the deposited metal film and surface of the metal composition target. The second atmosphere may, e.g., further comprise a noble gas as defined above in the context of the first atmosphere. The volume ratio between the reactive gas and the noble gas can be set, e.g. depending on the process parameters such as, e.g., the applied power, the power type (e.g. DC-power including DC magnetron-power, pulsed DC-power, pulsed DC magnetron-power or RF-power) used for plasma generation, the temperature and/or the duration of step (c). Depending on these process parameters, the first and second atmosphere may be of the same chemical composition and process parameters noted above are used to either effect sputtering during step (b) or the chemical modification during step (c).

If the first atmosphere differs from the second atmosphere, the atmosphere may be changed after step (b) and before step (c). The change in atmosphere can be achieved by purging or gradual exchange of the atmospheres, e.g. by adjusting the flow rates of the different gases. In an example, the change in atmosphere may occur seamless or while a plasma used for sputtering is extinguished while stabilizing the atmosphere followed by re-igniting the plasma for step (c). For example, the atmospheres in steps (b) and (c) may be generated by defining flow rates of the desired gases, e.g. in the range of 0 standard cubic centimeter per minute (sccm) to 150 sccm for each of the gases. The difference in gas flow is considered to yield a corresponding volume ratio for the purpose of the present invention (i.e. a flow rate of gas A = 1 sccm and gas B = 50 sccm results in a volume ratio of gas A : gas B = 1:50). The flow rates of the desired gases may be constant or, in the alternative, include gas bursts, e.g. from a reservoir.

In an embodiment of the method, the metal composition target is in solid form below about 150°C.

In an embodiment of the method, after step (c), the method further comprises step (d) of at least partially removing the chemically modified surface of the metal composition target, optionally under the first atmosphere. At least partial removal of the chemically modified surface of the metal composition target may be achieved by free sputtering of the metal composition target under suitable conditions (e.g. using the first atmosphere and suitable sputtering conditions). Exemplary conditions for free sputtering include applying a sputtering power density selected from 0.3 W/cm² to 2.4 W/cm² DC and/or 0.45 W/cm² to 3.1 W/cm² RF.

In an embodiment of the method, after step (d), the method further comprises repeating step (b) to deposit a further metal film on the surface of the substrate by sputtering the metal from the metal composition target under a third atmosphere, optionally the first atmosphere. Repeating step (b) means that a further metal film is deposited on the metal film that is deposited in a previous step (b). The repetition of step (b) may be conducted in the same vacuum chamber as the previous step (b), or in a different vacuum chamber. Also, if step (d) is carried out as free sputtering, step (d) may be carried out together with the repetition of step (b), i.e. step (d) is not performed prior to step (b) but concomitantly.

In an embodiment of the method, the method comprises repeating step (c) and optionally step (d). Repeating step (c) means that the further metal film of further step (b) is chemically modified. The repetition of step (c) may be conducted in the same vacuum chamber as the previous step (c), or in a different vacuum chamber.

In an embodiment, the method comprises repeating steps (b), (c) and (d) in this order to deposit and at least partially chemically modify multiple metal films on the surface of the substrate, optionally wherein the steps are repeated 2 to 120 times, optionally wherein step (d) is not performed after the last repetition of steps (b) and (c).

In an embodiment of the method, the chemically modified metal film of step (c) has a thickness of about 0.1 nm to 20 nm, optionally about 0.3 nm to 15 nm, optionally about 10 nm. The thickness indicated above refers to the thickness of the metal film after one iteration of step (b) and (c). If steps (b), (c) and optionally (d) are repeated, greater thicknesses can be achieved by multiple layers of the metal film, e.g. thicknesses of about 1 nm to about 1.5 µm.

In an embodiment of the method, the at least partially chemically modified metal film is an epitaxial film. The at least partially chemically modified film is the film that is obtained from step (c) of the present method, or from a repetition of steps (b), (c) and optionally (d) as outlined above.

In an embodiment of the method, the sputtering in step (b) is DC-sputtering, optionally DC magnetron-sputtering, pulsed DC-sputtering, or pulsed DC magnetron-sputtering; RF-sputtering; or a combination thereof. These conditions also optionally apply for step (d).

For example, an essentially planar magnetron system may be used as described on pages 4 to 5 of WO 2020/083882 A1, incorporated by reference in its entirety. Also, it is within the scope of the present invention that an inductively coupled plasma (ICP) is (e.g. additionally or alternatively) used in step (b).

In an embodiment of the method, the sputtering power density is selected from 0.3 W/cm² to 2.4 W/cm² DC and/or 0.45 W/cm² to 3.1 W/cm² RF.

The sputtering power density refers to the power density used for sputtering in step (b) and the area in cm² refers to the area of the surface of the metal composition target from which the metal is sputtered. For example, by adjusting the sputtering power and the sputtering power type (e.g. DC, pulsed DC, optionally in combination with a magnetron, or RF), the reaction conditions can be controlled in that also a first atmosphere comprising a reactive gas does not significantly lead to any chemical modification of the deposited metal film with the reactive gas.

In an embodiment of the method, in step (c), a reactive gas-comprising plasma is generated between the target and the substrate, wherein the reactive gas-comprising plasma optionally is a DC-plasma, an RF-plasma or a mixture thereof. Alternatively, a remote plasma (e.g. in a different vacuum chamber) may be used to create ions of the reactive gas of the second atmosphere which then lead to the at least partial chemical modification of the deposited metal film in step (c).

In an embodiment of the method, the power density for plasma generation in step (c) is selected from 0.24 W/cm² to 1.55 W/cm² DC and/or 0.3 W/cm² to 1.55 W/cm² RF. The area in cm² refers to the area of the surface of the metal composition target from which the metal is sputtered.

In an embodiment of the method, step (d) is performed under the conditions of step (b), optionally is performed as step (b), and wherein the chemically modified surface of the metal composition target is at least partially removed by sputtering. The sputtering used to at least partially remove the chemically modified surface of the metal composition target is also referred to as free sputtering and may occur additionally to other means of partial removal of the chemically modified surface of the metal composition target.

In an embodiment of the method, the first and/or third atmosphere comprises at least 60 vol% of a noble gas, and/or the second atmosphere comprises at least 5 vol% of a reactive gas. As noted above, the gas vol% can be generated by defining flow rates of the respective gases. The difference in gas flow is considered to yield a corresponding volume ratio for the purpose of the present method (i.e. a flow rate of gas A = 40 sccm and gas B = 60 sccm results in 60 volume-% of gas B).

In an embodiment of the method, the first and/or third atmosphere is a gas atmosphere free of a reactive gas or a gas mixture of noble gas and reactive gas with a volume ratio of about 1:0.6 or lower or 1:0.4 or lower, optionally from about 1:0.01 to about 1:0.6 or from about 1:0.01 to about 1:0.6, and/or the second atmosphere is a gas atmosphere consisting of a reactive gas or a gas mixture of noble gas and reactive gas with a volume ratio of about 1:0.6 or higher, optionally from about 1:0.6 to about 1:8, optionally from about 1:3 to about 1:4.

In an embodiment of the method, the noble gas is selected from the group consisting of Ar, Ne, Kr and Xe, and/or the reactive gas is a nitrogen-comprising gas, optionally selected from the group consisting of N₂, NH₃, N₂O and N₂H₄, or a gas selected from the group consisting of methane, acetylene, propane, O₂, CO₂ and H₂S. Mixtures of noble gases, nitrogen-comprising gases and methane, acetylene, propane, O₂, CO₂ and H₂S are within the scope of the present invention.

In an embodiment of the method, the chemical modification is a nitridation or oxidation. In an embodiment of the method, the chemical modification is a nitridation, and the reactive gas is a nitrogen-comprising gas, optionally selected from the group consisting of N₂, NH₃ and N₂H₄.

In an embodiment of the method, step (b) is performed for about 1 second to about 60 seconds, optionally about 3 seconds to about 15 seconds, and/or step (c) is performed for about 2 seconds to about 80 seconds, optionally about 5 seconds to about 35 seconds.

In an embodiment of the method, steps (b) and (c) are separated by no pause or by a pause of about 0.1 seconds to about 10 seconds, and/or wherein the steps (c) and (b), including step (d), are separated by no pause or by a pause of about 0.1 seconds to about 20 seconds. The process parameters (including the atmosphere) may be changed during the pause or seamlessly without a pause. If a plasma is generated during step (b), (c) and/or (d), this plasma may be turned off during the optional pause between the steps.

In an embodiment of the method, the substrate is heated in steps (b) and/or (c) to a temperature from about room temperature to about 900°C, optionally from about 500°C to about 900°C, optionally from about 650°C to about 850°C.

In an embodiment of the method, the substrate is selected from the group consisting of sapphire, a substrate having a GaN-surface, a substrate having an AlN-surface, a substrate having an AlGaN-surface, a substrate having an AlScN-surface, a substrate having a Si-surface and a substrate having a SiC-surface.

In an embodiment, the method further comprises doping the metal film on the surface of the substrate, in particular a metal film consisting of Ga and/or GaN, with a dopant selected from the group consisting of O, O₂, Zr, Ti, F, Ge, germane (GeH₄), isobutyl germane ((CH₃)₂CHCH₂GeH₃), Nb, S, Se, Mg, cyclopentadienyl magnesium (Cp₂Mg), Be, Ca, Zn, Mn, Cd, C and Fe.

Doping the metal film is, in the context of the present method, a different step from the step of at least partially chemically modifying the metal film. For example, doping may be performed during steps (b) and optionally (d) of the present method, e.g. by co-sputtering from a suitable target. For other doping methods, such as the introduction of a dopant gas or by evaporation or sputtering a dopant from an independent source, doping may be performed during any of steps (b), (c), and/or (d), or in an additional step, e.g. after step (b) or (c). If the dopant is a gas, it may be introduced as part of the first, second and/or third atmosphere.

In an embodiment of the method, the method further comprises doping the metal film on the surface with Si by introducing a silane gas, a SiH-compound, a SiH₂Cl₂-compund, a SiHCl₃-compound, a SiH₃Cl-compound a SiCl₄-compound or a combination thereof, optionally during step (b), (c), and/or (d), by thermal evaporation of Si, optionally during step (b), (c), and/or (d), and/or by sputtering from a Si-comprising target, optionally during step (b), (c), and/or (d).

In another aspect, a device is configured to perform the method disclosed herein and comprises a vacuum sputtering chamber comprising:
- a substrate holder,
- a metal composition target,
wherein the metal composition target is connected or connectable to a power supply,
- a vacuum port, and
- a gas inlet,
wherein the device further comprises a control unit configured, e.g. programmed by a computer program, to control and execute the steps according to the method described herein.

In an embodiment of the device, the metal composition target is connected or connectable to the cathode of a DC power supply, the cathode of a pulsed DC power supply, to a RF power supply or to a power supply providing a combination of DC, pulsed DC and/or RF power.

In an embodiment, the device does not comprise a shutter to cover the metal composition target and/or the substrate surface, and/or to avoid or reduce sputtering from the metal composition target and/or coating of the substrate during the step of chemically modifying the deposited metal film and/or during free sputtering. Alternatively, the device may comprise a shutter which, however, is not activated and/or positioned to cover the metal composition target and/or the substrate surface.

In an embodiment of the device, the substrate holder is connected or connectable to ground or a power supply, optionally a floating power supply. The power supply connected or connectable to the substrate holder can be a DC or RF power supply. In another embodiment, the device further comprises an anode electrically isolated from the metal composition target. In another embodiment of the device, the magnetron system is configured to induce a magnetic field with axisymmetric or non-axisymmetric geometry relative to an axis that is perpendicular to the surface of the metal composition target.

### BRIEF DESCRIPTION OF THE DRAWINGS

Embodiments of the current invention are described in more detail in the following with reference to the figures.

These are for illustrative purposes only and are not to be construed as limiting.
Figs. 1 to 3 show flowcharts for exemplary methods according to the present invention; and
Figs. 4 to 6 show exemplary devices according to the present invention.

### DETAILED DESCRIPTION OF THE DRAWINGS

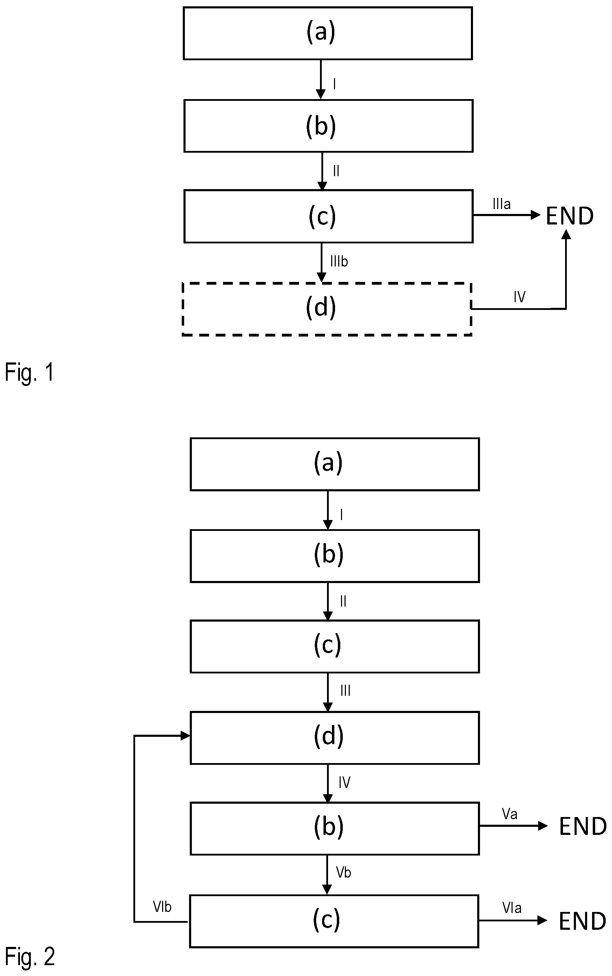

**Figure 1** shows a flowchart for an exemplary method with one iteration of steps (b) and (c), and optionally (d). After a substrate and a metal composition target (4) are provided in step (a), step (b) is carried out (arrow I), followed by step (c) (arrow II). After at least partially chemically modifying the deposited metal film and a surface of the metal composition target (4) with a reactive gas under a second atmosphere in step (c), the method can be ended (arrow IIIa) and the coated substrate can be removed from the vacuum chamber. Further processing (e.g. plasma etching or doping the metal film) of the coated substrate after step (c) is also possible, either in the same or in a different vacuum chamber. Alternatively, after step (c), step (d) can be carried out (arrow IIIb) and the method can be ended thereafter (arrow IV) leading essentially to the same product (coated substrate) as described for arrow IIIa, including the possibility for further processing as described above.

**Figure 2** shows a flowchart for an exemplary method with at least one repetition of steps (b) and (c) and including step (d) as a separate step. Steps (a), (b), (c) and (d) are carried out in this order (arrows I, II and III). After step (d), step (b) is repeated either under the same conditions as the previous step (b) or under different conditions (i.e. as step (b') as disclosed above), e.g. including a third atmosphere being different to the first atmosphere, a different metal composition target and/or different sputtering powers and power types. Hence, the same or a different metal film may be deposited on the previously deposited and chemically modified metal film. After the repetition of step (b), the method can be ended (arrow Va) without further chemical modification (a previously deposited layer in the first step (b) is chemically modified), or step (c) may be repeated (arrow Vb) under the same or different conditions as the first iteration of step (c). After the repetition of step (c), the method may be ended (arrow VIa). Alternatively, step (d) is repeated (arrow VIb), optionally followed by further steps (b) and/or (c). The explanations given above for the first repetition of steps (b) and (c) apply to the second and further repetitions of these steps. By repeating steps (b) and/or (c) (and optionally (d)), further layers of a (chemically modified) metal composition are added to the layers obtained from previous steps (b) and/or (c). Essentially, the steps may be repeated as many times as desired, e.g. until a certain film thickness or layer number is achieved.

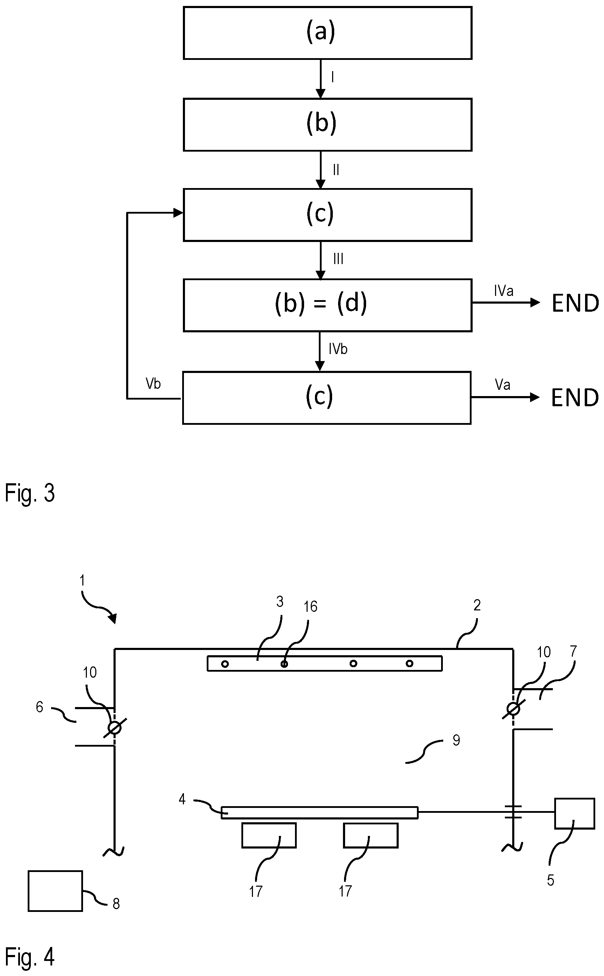

**Figure 3** shows a flowchart for an exemplary method with at least one repetition of steps (b) and (c), wherein step (d) is part of step (b). For example, the at least partial removal of the chemically modified surface of the metal composition target (4) may be achieved during step (b) by free sputtering of the metal composition target (4) under suitable conditions, while sputter deposition occurs essentially at the same time as soon as at least part of the chemically modified surface of the metal composition target (4) is available for sputtering. Exemplary conditions are provided above and the explanations given for figure 2 apply mutatis mutandis for figure 3.

**Figure 4** shows an exemplary device for conducting the method. The device (1) comprises a vacuum sputtering chamber (2) and, within the vacuum sputtering chamber, a substrate holder (3) (which may optionally comprise means for heating and/or cooling (16)) and a metal composition target in solid form. The metal composition target (4) may also be connected to heating and/or cooling means (not shown). The substrate holder (3) is configured to hold a substrate on the surface facing the metal composition target (4). The vacuum sputtering chamber (2) further comprises a vacuum port (6) and a gas inlet (7) which (each or only one of these) may optionally comprise regulating valves (10) for regulating gas flow and vacuum, respectively. The gas inlet is used for installing the first, second and optionally third atmosphere in the vacuum chamber. The metal composition target is connected or connectable to a sputter power supply (5). The power supply may be a cathode of a DC power supply, the cathode of a pulsed DC power supply, a RF power supply or a power supply providing a combination of DC, pulsed DC and/or RF power. A plasma (9) may be generated between the metal composition target (4) and a substrate on the substrate holder (3). A magnetron system (17) is used which - for all embodiments and figures disclosed herein - may be positioned outside of the vacuum chamber and includes symmetric or asymmetric magnetron systems. The magnetron system is static and the metal composition target is configured to rotate. Alternatively, the magnetron system may rotate and/or the metal composition target is static. The device further comprises a control unit (8) which executes the present method. The control unit may be positioned outside and detachably from the device and vacuum sputtering chamber and it is, at least during the operation of the method, connected to the relevant components of the device which determine the method parameters and steps, such as the gas inlet valve or any other suitable gas control means, the sputter power supply and optionally to means for heating and cooling the substrate and/or metal composition target. The vacuum chamber further comprises a substrate port (not shown) which may comprise a load lock for stand-alone systems or multi-chamber-systems operated with different pressure levels between successive process or transfer chambers.

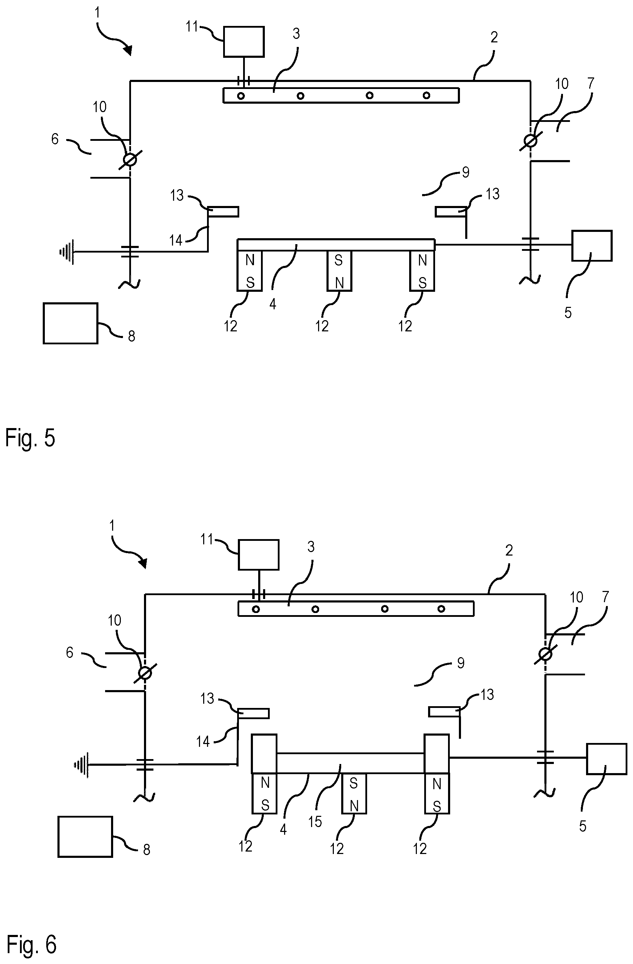

**Figure 5** shows another exemplary device. A power supply (11) is connected to the substrate holder which is in conductive contact with a substrate to be inserted during the method (the substrate holder may optionally comprise means for heating and/or cooling). The power supply (11) may alternatively be grounded, a DC or RF power supply or a floating power supply. An optional grounded anode (13) is electrically isolated from the metal composition target (4) (and its power supply (5)) and may optionally be positioned circumferentially around the metal composition target. An optional anode shield (14) may be mounted electrically isolated from the metal composition target in a dark room distance according to the process pressure applied. The vacuum sputtering chamber further comprises magnets (12) configured in an essentially planar magnetron system. To generate a magnetic field, the magnetron system comprises an outer closed magnet loop which is essentially perpendicular to the target surface with its magnetic axis M_{A}, and encloses the inner magnet(s) of inverse polarity being arranged in a central region of the target and vertically oriented with its magnetic axis M_{A}. Note that the pole orientation shown may be inversed. It should be mentioned that the outer magnet(s) may be arranged having a slightly oblique magnetic axis M_{A} tilted towards or against a central vertical axis, e.g. between 5° and 15°, to further design the overall magnetic field. The outer magnet may be, e.g. a ring-magnet or respectively arranged smaller magnets. The inner magnets, if more than one magnet is used, may be arranged linearly, or again as a closed loop, e.g. including linear and/or curved sections, for rectangular or other elongated targets, or as a central pole for square or circular targets, with all types essentially parallel but inverse to the magnetic axis M_{A} of the outer magnet loop. The control unit (8) in this example is, at least during the operation of the method, further connected to power supply (11).

**Figure 6** shows another exemplary device having a metal composition target (4) that comprises a metal composition (15). As for all embodiments, if the metal composition target is solid, it may be arranged below or above the substrate holder and substrate.

### EXAMPLES OF THE INVENTION

Embodiments of the present method are described in more detail in the following examples, none of which are to be interpreted as limiting the scope of the present invention. For the following examples, the cathode may be supplied with DC and RF (13.56MHz) voltages supplied by two separate generators. The anode may be arranged as needed, e.g. as a grounded shield which acts as anode. The magnetron is circular and slightly unbalanced such that the plasma extends more toward the substrate.

### Example 1 - General Procedure 1

In step (a), a substrate is provided, e.g. a sapphire or a silicon wafer. Exemplary substrate dimensions include 2 to 12 inch substrates. The metal composition target comprises a metal, such as gallium, indium, aluminium, mercury etc., and at least one secondary element, such as nitrogen, oxygen, arsenic, selenium etc, or another metal. For example, the metal composition target comprises gallium nitride (GaN), indium arsenide (InAs), mercury selenide (HgSe) etc. Exemplary target sizes include 200 mm to 340 mm diameter, and 300 cm³ to 10000 cm³ volume. For step (b), 0.3 W/cm² (area of the target) to 2.4 W/cm² DC and/or 0.24 W/cm² to 1.55 W/cm² RF power are applied to generate a plasma of a first atmosphere between the target and the substrate at a substrate temperature of about 500° to 900°C. The first atmosphere comprises a noble gas, e.g., about 40 vol% or more or 60 vol% or more of the noble gas. A metal film is deposited on the substrate by sputtering, e.g. during about 1 s to 50 s depending on the desired layer thickness. With or without interruption, the power is set for step (c) to no DC power or 0.24 W/cm² to 1.55 W/cm² DC, and/or no RF power or 0.3 W/cm² to 1.55 W/cm² RF (area of the target), and the atmosphere is changed to the second atmosphere to generate a reactive gas plasma of the second atmosphere between the target and the substrate. If the process is interrupted (e.g. for about 1 s to 15 s) between steps (b) and (c), the plasma may be turned off during that time. Without an interruption, the atmosphere may be changed gradually. The second atmosphere optionally comprises at least 5 vol% of a reactive gas, optionally selected from N₂, NH₃, N₂O and N₂H₄, and may, optionally, correspond to the first atmosphere. The substrate temperature during step (c) is about 500° to 900°C and step (c) may be carried out for, e.g., about 1 s to 50 s depending on the speed and desired degree of chemical modification. After step (c), an interruption or no interruption as described above may occur and optional step (d) may be carried out. If step (d) is exclusively performed as free sputtering of the surface of the metal composition target, step (d) may be carried out by performing step (b), either as a separate step before repeating step (b) or during the repetition of step (b) following step (c), wherein the conditions are chosen such that they are sufficient for free sputtering of at least the active surface area of the metal composition target used for sputtering. Thereafter, the sequence of steps (b) and (c) and optionally (d) are repeated until a desired thickness (i.e. layer number) of the deposited metal film is achieved.

### Example 2 - General Procedure 2

In step (a), a substrate is provided, e.g. a sapphire or a silicon wafer. Exemplary substrate dimensions include 2 to 6 inches. The metal composition target is a solid metal composition target, optionally a GaN target. Exemplary target sizes include 310 cm² area, and 1 cm to 3 cm thickness. For step (b), 0.3 W/cm² (area of the target) to 2.4 W/cm² DC and 0.24 W/cm² to 1.55 W/cm² RF power are applied to generate a plasma of a first atmosphere between the target and the substrate at a substrate temperature of about 500° to 900°C. The first atmosphere comprises about 40 vol% or more of the noble gas. For example, a gas flow of 25 sccm to 35 sccm of a noble gas and 8 sccm to 15 sccm of a reactive gas may be used to generate the first atmosphere. A metal film is deposited on the substrate by sputtering, e.g. during about 1 s to 30 s depending on the desired layer thickness. With or without interruption, the power is set for step (c), to (I) no DC power and 0.3 W/cm² to 1.55 W/cm² RF, or to (II) 0.24 W/cm² to 1.55 W/cm² DC and no RF power (area of the target). The first atmosphere is changed to the second atmosphere to generate a reactive gas plasma of the second atmosphere between the target and the substrate. If the process is interrupted (e.g. for about 1 to 15 s) between steps (b) and (c), the plasma may be turned off during that time. Without an interruption, the atmosphere may be changed gradually. The second atmosphere optionally comprises at least 5 vol% of a reactive gas, optionally selected from N₂ and NH₃, and may, optionally correspond to the first atmosphere. For example, a gas flow of 0 sccm to 26 sccm of a noble gas and 14 sccm to 45 sccm of a reactive gas can be used to generate the first atmosphere. The substrate temperature during step (c) is about 500° to 900°C and step (c) may be carried out, e.g., for about 1 s to 40 s depending on the speed and desired degree of chemical modification. After step (c), an interruption or no interruption as described above can occur and optional step (d) may be carried out. If step (d) is exclusively performed as free sputtering of the surface of the metal composition target, step (d) may be carried out by performing step (b), either as a separate step before repeating step (b) or during the repetition of step (b) following step (c), wherein the conditions are chosen such that they are sufficient for free sputtering of at least the active surface area of the metal composition target used for sputtering. Thereafter, the sequence of steps (b) and (c) and optionally (d) are repeated until a desired thickness (i.e. layer number) of the deposited metal film is achieved.

### Example 3 - Deposition example 1

In step (a), a single side polished sapphire substrate is provided with substrate dimensions of 2 inches. The metal composition target is a solid GaN target with a 314 cm² area, and 1.5 cm thickness. In step (b), 300 W DC and 500 W RF power are applied to generate a plasma of a first atmosphere between the target and the substrate at a substrate temperature of about 800°C. The first atmosphere is obtained from a gas flow of 30 sccm of Ar and 10 sccm of N₂. Sputtering is performed for 5 s to obtain a metal film of about 10 nm thickness. After step (b), and without pause (plasma on), the first atmosphere is changed to the second atmosphere by changing the gas flow to 5 sccm of Ar and 35 sccm of N₂. The power is changed to 0 W DC and 500 W RF to sustain the plasma of the second atmosphere between the target and the substrate at a substrate temperature of about 800°C. Step (c) is carried out for 12 s to obtain more than 95% chemical modification. Subsequently, the plasma is turned off for 3 s, the atmosphere is changed to the first atmosphere as described above, and step (b) is repeated as indicated above, followed by step (c). The cycle of steps (b) and (c) is repeated for a total of about 100 times to yield a thickness of 1000 nm and a conductivity of 618 µΩcm.

### Example 4 - Deposition example 2

In step (a), a single side polished sapphire is provided with dimensions of 2 inches. The metal composition target is a solid Ga target with a 314 cm² area, and 1.5 cm thickness. In step (b), 300 W DC and 300 W RF power are applied to generate a plasma of a first atmosphere between the target and the substrate at a substrate temperature of about 700 °C. The first atmosphere is obtained from a gas flow of 32 sccm of Ar and 8 sccm of N₂. Sputtering is performed for 5 s to obtain a metal film of about 15 nm. After step (b), a pause of 5 s is made (plasma off) during which time the first atmosphere is changed to the second atmosphere by changing the gas flow first to 5 sccm of Ar and 35 sccm of N₂ and then to 0 sccm of Ar and 40 sccm of N₂. The power is set to 300 W DC and 0 W RF to obtain a plasma of the second atmosphere between the target and the substrate at a substrate temperature of about 700 °C. Step (c) is carried out for 10 s to obtain of more than 95% chemical modification. Subsequently, the plasma is turned off for 5 s, the atmosphere is changed to the first atmosphere as described above, and step (b) is repeated as indicated above, followed by step (c). The cycle of steps (b) and (c) is repeated for a total of about 60 times to yield a thickness of 990 nm.

### Example 5 - Deposition example 3

In step (a), an Al₂O₃ substrate is provided with substrate dimensions of 2 inches. The metal composition target is a solid GaN target with a 314 cm² area, and 1.5 cm thickness. In step (b), 500 W DC and 500 W RF power are applied to generate a plasma of a first atmosphere between the target and the substrate at a substrate temperature of about 700 °C. The first atmosphere is obtained from a gas flow of 25.5 sccm of Ar and 14.5 sccm of N₂. Sputtering is performed for 10 s to obtain a metal film of about 18 nm. After step (b), no pause (plasma on) is made and the first atmosphere corresponded to the second atmosphere (gas flow is maintained at 25.5 sccm of Ar and 14.5 sccm of N₂). The power is changed to 0 W DC and 500 W RF to sustain the plasma of the second atmosphere between the target and the substrate at a substrate temperature of about 700 °C. Step (c) is carried out for 10 s to obtain more than 90% chemical modification. Subsequently, no pause (plasma on) is made and step (b) is repeated as indicated above, followed by step (c), all under the same gas flow conditions. The cycle of steps (b) and (c) is repeated for a total of 40 times to yield a thickness of 750 nm and an improved surface roughness (Rq about 7 nm) compared to prior art methods (Rq about 30 nm).

### REFERENCE SIGNS LIST

| | | | |
|---|---|---|---|
| 1 | Device | 9 | Plasma |
| 2 | Vacuum sputtering chamber | 10 | Regulating valve |
| | | 11 | Power supply |
| 3 | Substrate holder | 12 | Magnets for magnetron system |
| 4 | Metal composition target | | |
| | | 13 | Anode |
| 5 | Sputter power supply | 14 | Shield |
| 6 | Vacuum port | 15 | Metal composition |
| 7 | Gas inlet | 16 | Cooling/heating means |
| 8 | Control unit | 17 | Magnetron System |

## Claims

1. A method for depositing a chemically modified metal film on a substrate, wherein the method comprises the steps:
(a) providing a substrate and a metal composition target in a vacuum chamber,
(b) depositing a metal film on a surface of the substrate by sputtering a metal from the metal composition target under a first atmosphere, and
(c) at least partially chemically modifying the deposited metal film and a surface of the metal composition target with a reactive gas under a second atmosphere,
wherein the first atmosphere optionally is an atmosphere comprising at least 40 vol% of a noble gas, and
wherein the second atmosphere is an atmosphere comprising the reactive gas.

2. The method according to claim 1, wherein the metal composition target is a solid metal composition target, optionally a metal composition target that is in solid form below about 150°C.

3. The method according to claim 1 or 2, wherein after step (c), the method further comprises step (d) of at least partially removing the chemically modified surface of the metal composition target, optionally under the first atmosphere.

4. The method according to claim 3, wherein after step (d), the method further comprises repeating step (b) to deposit a further metal film on the surface of the substrate by sputtering the metal from the metal composition target under a third atmosphere, optionally the first atmosphere.

5. The method according to claim 4, wherein the method comprises repeating step (c) and optionally step (d).

6. The method according to claim 5, wherein the method comprises repeating steps (b), (c) and (d) in this order to deposit and at least partially chemically modify multiple metal films on the surface of the substrate, optionally wherein the steps are repeated 2 to 120 times, optionally wherein step (d) is not performed after the last repetition of steps (b) and (c).

7. The method according to any of claims 3 to 6, wherein step (d) is performed under the conditions of step (b), optionally is performed as step (b), and wherein the chemically modified surface of the metal composition target is at least partially removed by sputtering.

8. The method according to any of claims 1 to 7, wherein the chemical modification is a nitridation or oxidation.

9. The method according to any of claims 1 to 8, wherein the method further comprises doping the metal film on the surface of the substrate with a dopant selected from the group consisting of O, O₂, Zr, Ti, F, Ge, germane (GeH₄), isobutyl germane ((CH₃)₂CHCH₂GeH₃), Nb, S, Se, Mg, cyclopentadienyl magnesium (Cp₂Mg), Be, Ca, Zn, Mn, Cd, C, Fe, Mg and Sn.

10. The method according to any of claims 1 to 9, wherein the method further comprises doping the metal film on the surface with Si by at least one of
- introducing a silane gas, a SiH-compound, a SiH₂Cl₂-compund, a SiHCl₃-compound, a SiH₃Cl-compound a SiCL₄-compound or a combination thereof,
- thermal evaporation of Si, and
- sputtering from a Si-comprising target.

11. The method according to any of claims 1 to 10, wherein the metal composition of the metal composition target comprises an element that is comprised by the reactive gas.

12. A device (1) configured to perform the method according to any of claims 1 to 11, wherein the device comprises a vacuum sputtering chamber (2) comprising:
- a substrate holder (3),
- a metal composition target,
wherein the metal composition target is connected or connectable to a power supply (5),
- a vacuum port (6), and
- a gas inlet (7),
wherein the device further comprises a control unit (8) configured to control and execute the steps according to any of claims 1 to 11.
